(19) **Europäisches Patentamt**

**European Patent Office**

**Office européen des brevets**

(11) Veröffentlichungsnummer : **0 465 422 A2**

(12) **EUROPÄISCHE PATENTANMELDUNG**

(21) Anmeldenummer : **91810495.1**

(22) Anmeldetag : **25.06.91**

(51) Int. Cl.⁵ : **H05H 1/42, C23C 4/12**

(30) Priorität : **03.07.90 DE 4021182**

(43) Veröffentlichungstag der Anmeldung :
**08.01.92 Patentblatt 92/02**

(84) Benannte Vertragsstaaten :
**AT BE CH DE DK ES FR GB GR IT LI LU NL SE**

(71) Anmelder : **PLASMA TECHNIK AG**
**Rigackerstrasse 21**
**CH-5610 Wohlen 1 (CH)**

(72) Erfinder : **Hansz, Bernard**
**28 Rue Marcel Charon**
**F-91710 Vert le Pett (FR)**

(74) Vertreter : **Rottmann, Maximilian R. et al**
**c/o Rottmann, Zimmermann + Partner AG**
**Glattalstrasse 37**
**CH-8052 Zürich (CH)**

(54) **Vorrichtung zur Beschichtung der Oberfläche von Gegenständen.**

(57) Zur Beschichtung der Oberfläche von Gegenständen mit pulverförmigen Material ist eine Vorrichtung vorgesehen, die ein hitzebeständiges Rohr (13) aufweist, in welchem eine Plasma-flamme (19) erzeugt wird. Durch eine Zufuhrvorrichtung (14) wird das pulverförmige Beschichtungsmaterial in die Plasma-flamme (19) eingeführt, in dieser geschmolzen und auf der Oberfläche eines Gegenstandes (12) abgelagert. Zur Erzielung einer gleichmässigen Temperaturverteilung über den Querschnitt der Plasmaflamme (19) ist das hitzebeständige Rohr (13) mit einer ersten (16a) und einer zweiten (16b) Induktionsspule versehen. Die erste Spule (16a) wird mit einer höheren Frequenz, in der Grössenordnung von einigen MHz, und die zweite Spule (16b) mit einer tieferen Frequenz, in der Grössenordnung von ca. 50 bis 200 kHz, gespiesen.

Fig. 2

EP 0 465 422 A2

Die vorliegende Erfindung betrifft eine Vorrichtung zur Beschichtung der Oberfläche von Gegenständen mit einem pulverförmigen Material nach dem Oberbegriff des Patentanspruchs 1.

Zur Beschichtung der Oberfläche von Gegenständen mit pulververförmigem Material sind sogenannte Plasma-Beschichtungsvorrichtungen seit einigen Jahren bekannt. Bei diesen Vorrichtungen wird metallisches oder keramisches Pulver in einen Plasma-Lichtbogen eingeblasen und in diesem Lichtbogen erhitzt, wobei das pulverförmige Material schmilzt und anschliessend mit hoher Geschwindigkeit gegen die Oberfläche des zu beschichtenden Gegenstandes geschleudert wird.

Industriell verwendete Plasma-Beschichtungsvorrichtungen werden oftmals mit Gleichstrom betrieben, wobei ein Paar von Elektroden vorgesehen ist, um ein Trägergas, das in den Raum zwischen den Elektroden eingeblasen wird, zu ionisieren und damit, nach anfänglicher Zündung, einen Plasma-Lichtbogen aufrechtzuerhalten. Im Innern des Plasma-Lichtbogens herrschen sehr hohe Temperaturen, welche ausreichen, das in die so gebildete Plasmaflamme eingeführte, pulverförmige, metallische oder keramische Material zu schmelzen.

Ein diesen bekannten Gleichstrom-Plasma-Beschichtungsvorrichtungen gemeinsames Merkmal ist, dass das pulverförmige Material in die Plasmaflamme eingeblasen, dabei geschmolzen und auf eine verhältnismässig hohe Geschwindikeit beschleunigt wird, bevor es auf die Oberfläche des Gegenstandes auftrifft, der beschichtet werden soll. Die maximale Geschwindigkeit und die maximale Temperatur des Beschichtungsmaterials hängt dabei von den Eigenschaften der Plasmaflamme ab. Die vorstehend angesprochenen Gleichstrom-Plasma-Beschichtungsvorrichtungen sind in der Lage, bei relativ geringem Austrittsquerschnitt eine Austrittsgeschwindigkeit in der Grössenordnung von 100 - 300 m/s zu erreichen; dies ermöglicht allerdings nur eine relativ langsame Beschichtung der Oberfläche eines grösseren Gegenstandes. Aus diesem Grund sind derartige Vorrichtungen nur für kleine Gegenstände geeignet.

Eine andere Möglichkeit zur Erzeugung einer Plasmaflamme besteht darin, dem Plasmagas auf induktive Weise Energie zuzuführen, um nach der anfänglichen Zündung einen energiereichen Plasma-Lichtbogen aufrechtzuerhalten. Zu diesem Zweck ist ein hitzebeständiges Rohr vorgesehen, das einerends eine Zufuhrvorrichtung für das pulverförmige Beschichtungsmaterial sowie eine Zufuhrvorrichtung für das Plasmagas und im Bereich seines anderen Endes eine Induktionsspulen-Anordnung aufweist, die von einem Hochfrequenz-Generator mit Energie versorgt wird. Mit einer solchen Anordnung lässt sich zwar keine ausgesprochen grosse Austrittsgeschwindigkeit der im Plasma geschmolzenen Beschichtungspartikel erreichen, doch ist der nutzbare Querschnitt, verglichen mit der zuvor diskutierten Gleichstrom-Ausführung, wesentlich grösser, so dass sich eine derartige, induktiv-gekoppelte Plasma-Beschichtungsanordnung wesentlich besser zur Beschichtung von grösseren Gegenständen eignet.

In der US-PS 4,853,250 wurde eine Verbesserung der zuletzt genannten Vorrichtung beschrieben, bei welcher ermöglicht wird, dass die Austrittsgeschwindigkeit der in der Plasmaflamme geschmolzenen Beschichtungspartikel gegenüber bekannten Vorrichtungen wesentlich vergrössert werden kann. Während die Austrittsgeschwindigkeit bei älteren, derartigen Beschichtungsvorrichtungen in der Grössenordnung von ca. 10-30 m/s lag, ist es nach dem Vorschlag der vorgenannten US-PS möglich, eine Austrittsgeschwindigkeit des Beschichtungsmaterials von 100 m/s oder mehr zu erreichen.

Ein grosser Nachteil hat sich jedoch herausgestellt: Nicht nur bei konventionellen, induktiv gekoppelten Plasma-Beschichtungsvorrichtungen der hier zur Rede stehenden Art, sondern insbesondere auch bei der in der vorgenannten US-PS beschriebenen Vorrichtung ist der Nachteil zu beobachten, dass die Temperaturverteilung über den Querschnitt der Vorrichtung, d.h. im praktischen Fall über den Querschnitt des hitzebeständigen Rohres, auf welchem die Induktionsspule zur Erzeugung des Plasmas angebracht ist und innerhalb welchem eine Plasmaflamme vorhanden ist, sehr ungleichmässig ist. Mit anderen Worten: Im Bereich des Randes des hitzebeständigen Rohres ist die Temperatur beträchtlich höher, nimmt gegen das Zentrum des Rohres in etwa kontinuierlich ab und steigt bis zum diametral gegenüberliegenden Rand des hitzebeständigen Rohres wieder an.

Dieser Zustand ist natürlich nicht erwünscht, da er die Gleichmässigkeit der Beschichtung des zu beschichtenden Gegenstandes beeinträchtigen kann bzw. die Geschwindigkeit, mit der eine bestimmte Fläche eines Gegenstandes beschichtet werden kann, im negativen Sinn beeinflusst.

Ein weiterer Nachteil derartiger induktiv gekoppelter Plasma-Beschichtungsvorrichtungen besteht darin, dass vom Hochfrequenz-Generator eine verhältnismässig hohe Leistung zur Speisung der Induktionsspule aufgebracht werden muss, um das Plasma in der erwünschten Form und Stärke aufrechtzuerhalten. Da die Speisung der Induktionsspule üblicherweise mit einer Frequenz in der Grössenordnung von einigen MHZ bei einer Leistung von 25 - 150 kW erfolgt, ist es erforderlich, die eigentliche Auftragsvorrichtung, d.h. das hitzebeständige Rohr und die darauf aufgebrachte Induktionsspule sowie den Hochfrequenz-Generator, entweder integriert auszubilden oder sehr nahe beieinander anzuordnen, da bekanntlich die Übertragung von hohen Leistungen im Bereich von mehreren Dutzend kW bei einer Frequenz von mehreren MHZ über längere Distanzen problematisch ist.

Es ist die Aufgabe der vorliegenden Erfindung, eine Vorrichtung zur Beschichtung der Oberfläche von Gegenständen mit einem pulverförmigen Material derart weiterzubilden, dass das Temperaturspektrum über dem Querschnitt der Auftragsvorrichtung gemessen wesentlich gleichmässiger ist, und dass die Energieübertragung zwischen Stromversorgungseinheit und Induktionsspulen-Anordnung einfacher, d.h. auch über grössere Distanzen problemloser, zu bewerkstelligen ist.

Gemäss der Erfindung wird diese Aufgabe bei einer Vorrichtung der im Oberbegriff des Patentanspruchs 1 genannten Art dadurch gelöst, dass die Induktionsspulen-Anordnung mindestens zwei getrennte Spulen aufweist, die vom Hochfrequenz-Generator mit unterschiedlichen Frequenzen gespiesen werden.

Im Normalfall wird es genügen, innerhalb der Induktionsspulen-Anordnung zwei Spulen vorzusehen, die in Axialrichtung des hitzebeständigen Rohres nebeneinander angeordnet sind. Selbstverständlich ist es aber auch möglich, drei oder noch mehr in Axialrichtung nebeneinander angeordnete Spulen vorzusehen, sofern man eine weiter gesteigerte Gleichmässigkeit des Temperaturverlaufs über den Querschnitt des hitzebeständigen Rohrs erzielen will.

Im üblichen Fall mit zwei axial nebeneinander angeordneten Spulen ist eine erste Spule zweckmässigerweise im Bereich des Auslasses der Zufuhrvorrichtung für das pulverförmige Beschichtungsmaterial und eine zweite Spule axial daran anschliessend, an dem der Zufuhrvorrichtung für das pulverförmige Beschichtungsmaterial abgewandten Ende des hitzebeständigen Rohres angeordnet.

Zweckmässigerweise wird die vorgenannte erste Spule mit einer höheren Frequenz, vorteilhafterweise mit mindestens der doppelten Frequenz, gespiesen als die vorgenannte zweite Spule. In der Praxis hat es sich als zweckmässig erwiesen, die erste Spule mit einer Frequenz von etwa 2 - 5 MHZ und die zweite Spule mit einer Frequenz von etwa 50 - 200 KHZ zu speisen.

Im Interesse eines optimalen Betriebs der Vorrichtung bezüglich des Wirkungsgrades ist folgendes zu beachten: Da die rein physikalische Anordnung der beiden Spulen auf dem hitzebeständigen Rohr gegeben und für jede der beiden Spulen relativ ähnlich ist, sollte für eine optimale Anpassung an die Ausgangsfrequenz des jeder Spule zugeordneten Generatorteils gesorgt werden. Mit anderen Worten ausgedrückt bedeutet dies, dass die sich aus der physikalischen Spulenanordnung ergebende Induktivität mit Hilfe eines parallel geschalteten Kondensators an die Frequenz des Hochfrequenz-Generators derart angepasst ist, dass bei jeder Spule die aus Kapazität des Kondensators und Induktivität der Spule resultierende Resonanzfrequenz gleich der Frequenz der vom Hochfrequenz-Generator an die betreffende Spule gelieferten Spannung ist.

Im einfachsten Fall, bei welchem eine erste Spule im Bereich des Auslasses der Zufuhrvorrichtung für das pulverförmige Beschichtungsmaterial und eine zweite Spule daran axial anschliessend im Bereich des Auslassendes des hitzebeständigen Rohres vorgesehen ist, wird die erste Spule zweckmässigerweise mit einer höheren Leistung gespiesen als die genannte zweite Spule. Das Verhältnis der Leistungsaufnahme der beiden Spulen liegt dabei zwischen 1:0.6 und 1:0.9, vorzugsweise etwa bei 1:0.8. Überraschenderweise hat sich dabei gezeigt, dass die Summe der Leistungsaufnahmen der beiden Spulen zur Aufrechterhaltung eines bestimmten Plasma-Lichtbogens wesentlich geringer ist als wenn nur, wie im Stand der Technik, eine einzige Spule verwendet wird. Um dies optimal einzustellen, kann die Zufuhrvorrichtung für das Beschichtungsmaterial durch ein koaxial zum hitzebeständigen Rohr angeordnetes Rohr geringeren Durchmesser gebildet sein, welches in relativ zum hitzebeständigen Rohr axialer Richtung verschiebbar ist.

Im folgenden wird ein Ausführungsbeispiel unter Bezugnahme auf die beiden Zeichnungen näher erläutert. In den Zeichnungen zeigen:

Fig. 1 einen Querschnitt durch eine Beschichtungsvorrichtung mit induktiver Koppelung zur Zufuhr von Energie zwecks Aufrechterhaltung des Plasma-Lichtbogens nach dem Stand der Technik;

Fig. 2 einen Querschnitt durch eine Beschichtungsvorrichtung mit induktiver Koppelung zur Zufuhr von Energie zwecks Aufrechterhaltung des Plasma-Lichtbogens gemäss der Erfindung;

Fig. 3 ein Temperaturdiagramm; und

Fig. 4 ein elektrisches Schaltbild.

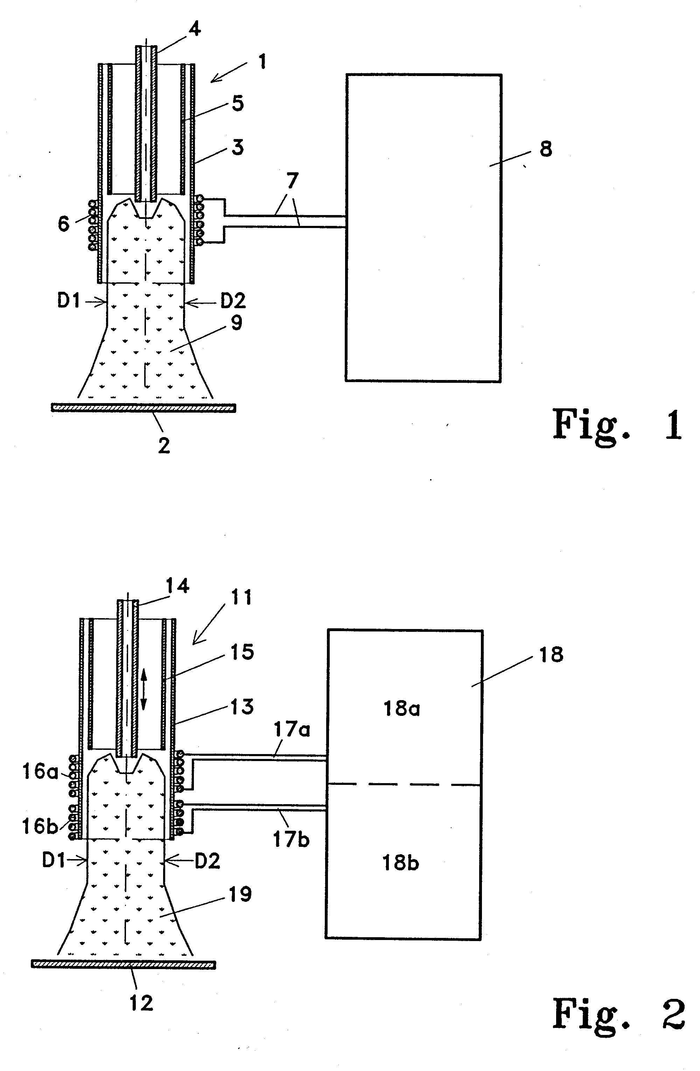

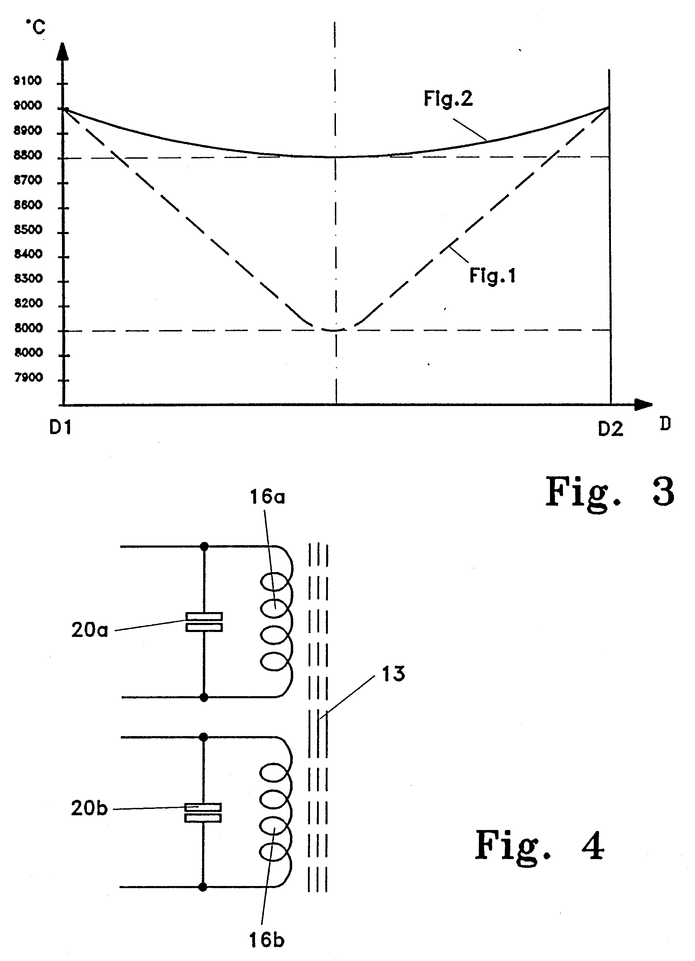

In der Fig. 1 ist eine generell mit 1 bezeichnete Plasma-Beschichtungsvorrichtung nach dem Stand der Technik dargestellt, welche dazu geeignet ist, einen Gegenstand 2 auf seiner Oberfläche mit einem pulverförmigen Material zu beschichten. Die Plasma-Beschichtungsvorrichtung 1 besitzt einen hitzebeständigen, rohrförmigen Körper 3, welcher beispielsweise aus Quarzglas hergestellt sein kann. Im Innern des rohrförmigen Körpers 3 ist eine Vorrichtung zur Zuführung des pulverförmigen Beschichtungsmaterials angeordnet; diese Vorrichtung kann zweckmässigerweise die Form eines Rohrs 4 besitzen. Ein weiteres Rohr 5 ist ebenfalls konzentrisch zum rohrförmigen Körper 3 innerhalb des letzteren angeordnet; das Rohr 5 besitzt geringfügig geringeren Durchmesser als der rohrförmige Körper 3, wobei in den Zwischenraum zwischen rohrförmigem Körper 3 und dem Rohr 5 ein Kühlgas eingeblasen werden kann.

Der rohrförmige Körper 3 ist im Bereich des Auslasses der Zufuhrvorrichtung für das Beschichtungsmaterial mit einer Induktionsspule 6 versehen, welche über Leitungen 7 mit einem Hochfrequenz-Generator 8 verbunden ist.

Wenn der Spule 6 über die Leitungen 7 Hochfrequenzenergie, z.B. in der Grössenordnung von 50-250 kW mit einer Frequenz von 2-4 MHz zugeführt wird, und wenn in den Zwischenraum zwischen dem Zufuhrrohr 4 und dem Rohr 5 ein inertes Gas, z.B. Argon, eingeblasen wird, wird sich im Bereich des unteren Endes des rohrförmigen Körpers 3 nach anfänglicher Zündung eine Plasmaflamme 9 ausbilden. Durch das Zufuhrrohr 4 wird das pulverförmige Beschichtungsmaterial mit Hilfe eines Trägergases in den rohrförmigen Körper 3 und damit in die Plasmaflamme 9 eingeblasen.

Aufgrund der Tatsache, dass in der Plasmaflamme 9 sehr hohe Temperaturen herrschen, wird das pulverförmige Beschichtungsmaterial sofort geschmolzen und prallt in geschmolzenem Zustand mit hoher Geschwindigkeit auf die Oberfläche des zu beschichtenden Körpers 2.

In der Fig. 3 ist aus der gestrichelt gezeichneten Linie der Temperaturverlauf über den Querschnitt $D_1$-$D_2$ des rohrförmigen Körpers 3 ersichtlich. Dabei wird deutlich, dass die Temperatur im Bereich der Wände des rohrförmigen Körpers 3 wesentlich grösser, d.h. im Bereich von etwa 9000° C ist, und dass die Temperatur bis zur Mittelachse des rohrförmigen Körpers 3 kontinuierlich auf ca. 8000° C abnimmt. Dies ist insofern unerwünscht, als dadurch ein ungleichmässiges Aufschmelzen des pulverförmigen Beschichtungsmaterials und damit eine ungleichmässige Beschichtungsqualität auf der Oberfläche des Gegenstandes 2 resultiert.

In Fig. 2 ist die erfindungsgemässe Lösung dargestellt. Die Plasma-Beschichtungsvorrichtung, generell mit 11 bezeichnet, dient wiederum zur Beschichtung der Oberfläche eines Gegenstandes 12 und besitzt einen rohrförmigen Körper 13, welcher mit einem konzentrisch angeordneten Zufuhrrohr 14 mit wesentlich geringerem Durchmesser für die Zufuhr des pulverförmigen Beschichtungsmaterials mittels eines Trägergases sowie mit einem weiteren Rohr 15 versehen ist, welches etwas geringeren Durchmesser als der rohrförmige Körper 13 besitzt, wobei in analoger Weise durch den Zwischenraum zwischen rohrförmigem Körper 13 und Rohr 15 ein Kühlgas eingeblasen werden kann.

Im Gegensatz zur Ausführung gemäss Fig. 1 besitzt die Plasma-Beschichtungsvorrichtung 11 gemäss der Erfindung zwei in Achsialrichtung des rohrförmigen Körpers 13 nebeneinander angeordnete Spulen 16a und 16b. Der Hochfrequenz-Generator 18 ist in der Lage, zwei bezüglich Frequenz und Leistung unterschiedliche Speisespannungen zu liefern; ein Teil 18a des Hochfrequenz-Generators ist an die Spule 16a angeschlossen, und ein Teil 18b des Hochfrequenz-Generators ist an die Spule 16b angeschlossen.

Im Ausführungsbeispiel gemäss Fig. 2 sind zwei achsial nebeneinander angeordnete Spulen 16a und 16b vorgesehen. Gemäss der Erfindung ist wesentlich, dass mindestens zwei Spulen vorhanden sind. Im Bedarfsfall können jedoch auch drei oder mehr Spulen achsial nebeneinander angeordnet sein.

Im vorliegenden Beispiel wird die erste Spule 16a, die im Bereich des Auslasses des Zufuhrrohres 14 für das Beschichtungsmaterial angeordnet ist, mit einer höheren Frequenz gespiesen als die zweite Spule 16b, die im Bereich des Auslasses des rohrförmigen Körpers 13 angeordnet ist. Zweckmässigerweise wird die Spule 16a mit einer Frequenz zwischen 1 und 10 MHz, vorzugsweise 2 bis 5 MHz, und die Spule 16b mit einer Frequenz von 20 bis 500 kHz, vorzugsweise 50 bis 200 kHz, gespiesen.

Überraschenderweise hat es sich gezeigt, dass der Spule 16a, d.h. der im Bereich des Auslasses der Zufuhrvorrichtung 14 für das pulverförmige Beschichtungsmaterial liegenden Spule, weniger Energie zugeführt werden muss als der achsial benachbart liegenden Spule 16b, die mit der niedrigeren Frequenz gespiesen wird. Das Verhältnis der Leistungsaufnahme der beiden Spulen liegt dabei etwa zwischen 0.6:1 und 0.9:1, vorzugsweise bei etwa 0.85:1.

Noch weiter überraschend ist die Tatsache, dass die Gesamtleistung, welche den beiden Spulen 16a und 16b zugeführt werden muss, um einen bestimmten Plasma-Lichtbogen aufrecht zu erhalten, deutlich geringer ist, wenn die beiden Spulen 16a und 16b mit Frequenzen der vorgenannten Grössenordnung versorgt werden, als wenn nur eine einzige Spule gemäss Fig. 1 vorgesehen ist, die mit einer Frequenz von z.B. zwischen 2 bis 5 MHz gespiesen wird.

Da die beiden Spulen 16a und 16b im Prinzip ähnliche physikalische Konfiguration besitzen, somit auch ähnliche Induktivität aufweisen, jedoch mit deutlich unterschiedlichen Frequenzen gespiesen werden, ist es vorteilhaft, eine elektrische Anpassung vorzunehmen, um den Wirkungsgrad der gesamten Anordnung zu verbessern. Zu diesem Zweck ist vorgesehen, der Spule 16a einen ersten Kondensator 20a und der Spule 16b einen zweiten Kondensator 20b parallel zu schalten, wie dies aus Fig. 4 schematisch ersichtlich ist. Die Kapazität des ersten Kondensators 20a wird dabei so gewählt, dass sich die aus der Induktivität der Spule 16a und der Kapazität des Kondensators 20a ergebende Resonanzfrequenz gleich der Frequenz der Ausgangsspannung des Generatorteils 18a ist. In entsprechender Weise wird die Kapazität des zweiten Kondensators 20b so gewählt, dass sich die aus der Induktivität der Spule 16b und der Kapazität des Kondensators 20b ergebende Resonanzfrequenz gleich der Frequenz der Ausgangsspannung des zweiten Generatorteils 18b ist. Damit ist eine optimale Ankoppelung der beiden Induktionsspulen 16a und 16b erreicht.

Eine weitere Optimierung des Wirkungsgrades der Vorrichtung 11 kann dadurch erreicht werden, dass das Rohr 14 für die Zufuhr des pulverartigen Beschichtungsmaterials in Achsialrichtung verschiebbar ist, wie dies durch den Doppelpfeil in Fig. 2 angedeutet wird. Damit lässt sich die Plasmaflamme 19 in den optimalen Bereich innerhalb der beiden Induktionsspulen 16a und 16b verlegen.

Ein Vorteil der erfindungsgemäss Anordnung ist, dass die Temperaturverteilung über dem Durchmesser des rohrförmigen Körpers 13 wesentlich gleichmässiger ist. Aus Fig. 3 geht hervor, dass, verglichen mit der Ausführung gemäss Fig. 1, die im Bereich der Wand des Rohres 13 herrschende Temperatur ebenfalls bei ca. 9000° C liegt, dass die Temperatur jedoch, wie aus der ausgezogen gezeichneten Linie ersichtlich, gegen das Zentrum des rohrförmigen Körpers 13 hin lediglich auf ca. 8800° C abfällt. Damit ergibt sich eine wesentlich gleichmässigere Qualität in der Beschichtung der Oberfläche des Gegenstandes 12.

Ein weiterer Vorteil der erfindungsgemäss Vorrichtung liegt darin, dass über die Leitungen 17a zwischen Generatorteil 18a und Spule 16a und über die Leitung 17b zwischen Generatorteil 18b und Spule 16b wesentlich kleinere Leistungen übertragen werden müssen als über die einzige Leitung 7 in der Vorrichtung gemäss Fig. 1. Da bekanntlich die Übertragung hochfrequenter Ströme beträchtlicher Grössenordnung über längere Distanzen problematisch ist, ergibt sich hiermit der Vorteil, dass der Generator 18 getrennt von der eigentlichen Beschichtungsvorrichtung 11 angeordnet werden kann, so dass die eigentliche Beschichtungsvorrichtung 11 wesentlich mobiler ist.

Ein letzter nicht zu unterschätzender Vorteil ist schliesslich darin zu sehen, dass der Gesamt-Energieverbrauch gegenüber einer konventionellen Beschichtungsvorrichtung, z.B. wie in Fig. 1 gezeigt, beträchtlich geringer ist und je nach Ausführung der Anlage nur noch etwa 60% beträgt.

## Patentansprüche

1. Vorrichtung zur Beschichtung der Oberfläche von Gegenständen (12) mit einem pulverförmigem Material, bei welcher das Material in einem Plasma-Lichtbogen (19) geschmolzen wird, mit einem hitzebeständigen Rohr (13), das einerends eine Zufuhrvorrichtung (14) für das Beschichtungsmaterial sowie eine Zufuhrvorrichtung für das Plasma-Gas und im Bereich seines anderen Endes eine Induktionsspulen-Anordnung (16a, 16b) aufweist, wobei die Induktionsspulen-Anordnung an einen Hochfrequenz-Generator (18) angeschlossen ist, dadurch gekennzeichnet, dass die Induktionsspulen-Anordnung mindestens zwei getrennte Spulen (16a, 16b) aufweist, die vom Hochfrequenz-Generator (18) mit unterschiedlichen Frequenzen gespiesen werden.

2. Vorrichtung nach Anspruch 1, dadurch gekennzeichnet, dass die Induktionsspulen-Anordnung zwei Spulen (16a, 16b) umfasst, die in Axalrichtung des hitzebeständigen Rohrs (13) nebeneinander angeordnet sind.

3. Vorrichtung nach Anspruch 2, dadurch gekennzeichnet, dass die eine Spule (16a) im Bereich des Auslasses der Zufuhrvorrichtung (14) für das Beschichtungsmaterial und die andere Spule (16b) daran anschliessend, am der Zufuhrvorrichtung für das Beschichtungsmaterial abgewandten Ende des hitzebeständigen Rohrs (13), angeordnet ist.

4. Vorrichtung nach einem der vorhergehenden Ansprüche, dadurch gekennzeichnet, dass eine Spule (16a) der Induktionsspulen-Anordnung mit mindestens der doppelten Frequenz gespiesen wird wie eine andere Spule (16b).

5. Vorrichtung nach Patentanspruch 4, dadurch gekennzeichnet, dass eine Spule (16a) der Induktionsspulen-Anordnung mit 1-10 MHz, vorzugsweise 2-5 MHZ, und eine andere Spule (16b) mit 20-500 kHz, vorzugsweise 50-200 kHZ gespiesen wird.

6. Vorrichtung nach einem der vorhergehenden Ansprüche, dadurch gekennzeichnet, dass eine im Bereich des Auslasses der Zufuhrvorrichtung (14) für das Beschichtungsmaterial liegende Spule (16a) mit der höheren Frequenz gespiesen wird.

7. Vorrichtung nach einem der vorhergehenden Ansprüche, dadurch gekennzeichnet, dass jeder Spule (16a; 16b) der Induktionsspulen-Anordnung je ein Kondensator (20a; 20b) parallelgeschaltet ist.

8. Vorrichtung nach Anspruch 7, dadurch gekennzeichnet, dass die Grösse des der jeweiligen Spule (16a; 16b) parallelgeschalteten Kondensators (20a; 20b) derart gewählt ist, dass sich die aus Kapazität des Kondensators und Induktivität der Spule ergebende Resonanzfrequenz gleich der Frequenz der vom Hochfrequenzgenerator (18) an die betreffende Spule gelieferten Spannung ist.

9. Vorrichtung nach einem der vorhergehenden Ansprüche, dadurch gekennzeichnet, dass die im Bereich des Auslasses der Zufuhrvorrichtung (14) für das Beschichtungsmaterial liegende Spule (16a) eine geringere Leistungsaufnahme besitzt bzw. dass dieser Spule (16a) eine geringere Leistung zugeführt wird als die bzw. der benachbarte(n) Spule(n) (16b).

10. Vorrichtung nach einem der Ansprüche 2-9, dadurch gekennzeichnet, dass das Verhältnis der Leistungsaufnahme der beiden Spulen (16a bzw. 16b) zwischen 0.6 : 1 und 0.9 : 1, vorzugsweise zwischen 0.8 : 1 und 0.9 : 1 liegt.

11. Vorrichtung nach einem der vorhergehenden Ansprüche, dadurch gekennzeichnet, dass die Zufuhrvorrichtung (14) für das Beschichtungsmaterial durch ein koaxial zum hitzebeständigen Rohr (13) angeordnetes Rohr (14) geringeren Durchmessers gebildet ist, welches in relativ zum hitzebeständigen Rohr (13) axialer Richtung verschiebbar gelagert ist.

Fig. 1

Fig. 2

Fig. 3

Fig. 4